# EUROPEAN PATENT APPLICATION

(11) **EP 2 407 315 A1**
(43) Date of publication of application: **18.01.2012**
(21) Application number: 11425140.8
(22) Date of filing: 25.05.2011
(51) Int. Cl.: B41M 5/00, B41M 7/00, B65D 51/24, B44C 3/02, B44D 5/00, C23C 14/02

(54) **Method for producing stoppers for vessels**

(71) Applicant: TAPEMATIC S.p.A., 23807 Merate (LC) (IT)
(72) Inventor: Perego, Luciano, 23807 Merate (Lecco) (IT)
(74) Representative: Vittorangeli, Lucia

(57) **Abstract**

A method of producing stoppers for vessels comprises the steps of providing a prismatic element (2) having at least one side wall (3) and one top wall (4) defining an inner cavity (5), laying printing ink (6) only on some portions of the side wall (3) and/or the top wall (4), the portions on which printing ink (6) has been laid reproducing a predetermined motif (6a) then, subsequent to deposition of the printing ink (6), fully metallising both the side surface (3) the top surface (4) by a surface deposition process for laying a thin metal layer (8), preferably through the sputtering technique.

## Description

The present invention relates to a method of producing stoppers for vessels.

For a long time vessels and related stoppers have taken a very important role as regards marketing of the product contained in the vessel.

In other words, for drawing the consumer's attention on a product marketed in vessels, the latter and the related stoppers are carefully planned and designed in such a manner as to reproduce particular shapes, and are often made of valuable materials.

Going round the shelves of a supermarket it is possible to see vessels, such as oil bottles, bottles for wines and spirits and bottles containing cosmetics, shampoos and the like, the stoppers of which have badges, inscriptions, effigies or decorations.

These badges, inscriptions, effigies or decorations are often perceptible both to the eye and to the touch as being in relief, and the stopper is often made of metal material in such a manner that it appears to be particularly valuable and is able to transfer its value to the product contained in the vessel.

These stoppers, as above mentioned, are preferably made of metal material and the relief badges, inscriptions, effigies or decorations are obtained through embossing of the stopper surface.

In particular, the stopper surface is selectively, i.e. following a particular design, plastically deformed (by plastic deformation being intended a permanent deformation), in such a manner that some parts of the stopper emerge from the underlying surface thus creating said relief badges, inscriptions, effigies or decorations.

Clearly, this operation is carried out on the stoppers before the latter are associated with the vessel, because for the embossing operation the combined action of pressure and temperature is required, which could not be implemented on a stopper already applied to the vessel.

While the above described stoppers of the known art are widely spread and very efficient from a commercial point of view, they have some drawbacks.

In fact, in a great number of applications the vessels are filled with the respective product and subsequently closed with stoppers in an automatic manner, i.e. through use of automatic machines carrying out transport and handling both of the vessels and the stoppers.

In this regard, increasingly more spread have been the automatic machines that pick up the empty vessels, transfer them under a filling station, fill them, move them to a closing station and carry out closure of the vessels with the stoppers.

Stoppers too are handled and transferred to the closing station where they are applied to the already filled vessels.

During transport and more particularly during coupling with the vessel, the stoppers are submitted to crushing actions by the gripping element and tightening actions by the automatic machine.

While these crushing actions have been suitably regulated during the planning step of the automatic machine to avoid the stoppers being damaged, sometimes they can damage the relief badges, inscriptions, effigies or decorations present on the stoppers.

In fact, should the crushing action be exerted exactly on a stopper portion in relief, this portion could be "flattened", i.e. deformed in the opposite way relative to the plastic deformation obtained with the embossing process, which would impair the relief badge, effigy or decoration.

The aforesaid drawback is still more present when the stopper is a screw plug, as it needs to be screwed down with a non-negligible tightening torque on the bottleneck.

In this context, the technical task of the present invention is to make available a method of producing stoppers for vessels which is free of the above mentioned drawbacks.

In particular, it is an aim of the present invention to provide a method of producing stoppers for vessels capable of ensuring the integrity of the stopper and the related relief motifs during handling and coupling of said stopper with the vessel.

Further features and advantages will become more apparent from the detailed description of a preferred and not exclusive embodiment of a method of producing stoppers for vessels according to the invention.

This description will be provided with reference to the accompanying drawings, given by way of non-limiting example as well, in which:
- Fig. 1 is a perspective view with some parts removed so that others may be rendered more prominent, of a stopper produced by a method in accordance with the present invention; and
- Fig. 2 is an enlarged view of a detail seen in Fig. 1.

With reference to the drawings, a stopper produced following the method in accordance with the present invention has been generally identified as 1.

The method of producing stoppers for vessels comprises a first step of providing a prismatic element 2 having at least one side wall 3 and one top wall 4 defining an inner cavity 5.

The inner cavity 5 can have a thread (not shown) suitable for engagement with the thread of a bottleneck, should the stopper be a screw plug.

By "prismatic element" it is intended, within the context of the present invention, a preferably cylindrical three-dimensional element, adapted to be fitted on the neck of a vessel and, following further working operations (screwing, for example), adapted to prevent escape of the product contained in the vessel.

In the preferred embodiment of the invention, the prismatic element 2 is a hollow cylindrical body provided with a side wall 3 and a substantially flat top wall 4.

In the following of the specification, reference will be made to the "outer surface" of the prismatic element for indicating the side wall 3 and top wall 4.

It should be noted that other shapes suit the purpose, such as prisms of quadrangular section and oval section, for example.

By the term "providing a prismatic element" it is intended in the context of the present invention, "having a prismatic element at one's disposal", i.e. "being supplied with a prismatic element", irrespective of the fact that this provision takes place by directly manufacturing the prismatic element or merely coming into possession of the element when already manufactured.

Accomplishment of the prismatic element can be carried out in any manner, i.e. following any technique.

In addition, the prismatic element can be made up of any material, preferably metal or plastic material.

By way of example, the prismatic element can be obtained by drawing of a sheet or foil (should the prismatic element be of metal) or by moulding (should the prismatic element be of plastic material).

The method of the present invention contemplates laying of printing ink 6 on some portions of the side wall and/or top wall of the prismatic element reproducing a predetermined motif 6a.

Note that the step of laying ink 6 does not concern the whole outer surface of the prismatic element, but only some portions of same. In other words, printing ink is not laid down on some portions of the outer surface of the prismatic element.

Laying of the printing ink 6 follows a predetermined motif 6a, i.e. reproduces an inscription, badge, logo, brand, effigy, decoration, photographic reproduction or a combination thereof on the outer surface of the prismatic element. In the embodiment shown in the drawings, the motif 6a is a rhomboidal geometric motif.

The step of laying printing ink can take place using any printing technique, inkjet, silk-screen printing, pad-printing, flexography, offset for example.

Preferably, this step is carried out using the digital printing. The term "digital printing" is understood as indicating any printing technique that does not contemplate use of printing plates, printing frames, relief plates or the like, and in which printing directly occurs through a graphic file processed by the printing device (the printing heads).

In particular, the printing technique offering the best results is the inkjet printing. In fact, this printing technique when used in the method of the present invention enables any contact with the surface of the prismatic element to be avoided, therefore ensuring easy and quick printing on the curved side wall 3 of the prismatic element 2.

In addition, by this printing technique it is possible to choose, through software, the amount of ink to be laid, being able to *a priori* determine and select the thickness of the laid ink.

This feature is particularly advantageous in the context of the present invention, as it will become more apparent in the following.

Specifically, depending on the type of motif 6a and the type of material the prismatic element 2 is made of, the inkjet printing can be multi pass, single pass, fixed dot size, variable dot size.

Note that the printing time, i.e. the time required for laying the ink on the outer surface of the prismatic element 2 is included between 0.1 and 2 seconds depending on the printing head used and the sizes of the prismatic element (that in any case are in the order of few centimetres).

Preferably, the printing ink used is of the UV type, i.e. an ink containing a photostarter that, submitted to UV radiation gives rise to a chain cross-linking reaction of the ink.

In addition, preferably, the ink used does not contain any solvents (or contain them to a minimum extent).

After the step of laying the printing ink on some surface portions of the prismatic element 2, the latter is submitted to a step of drying the laid ink. To this aim, a drying step by UV rays is provided so as to cause cross-linking of the ink.

Note that exposure of the prismatic body to UV rays is in the order of a few seconds (0.4-4 seconds).

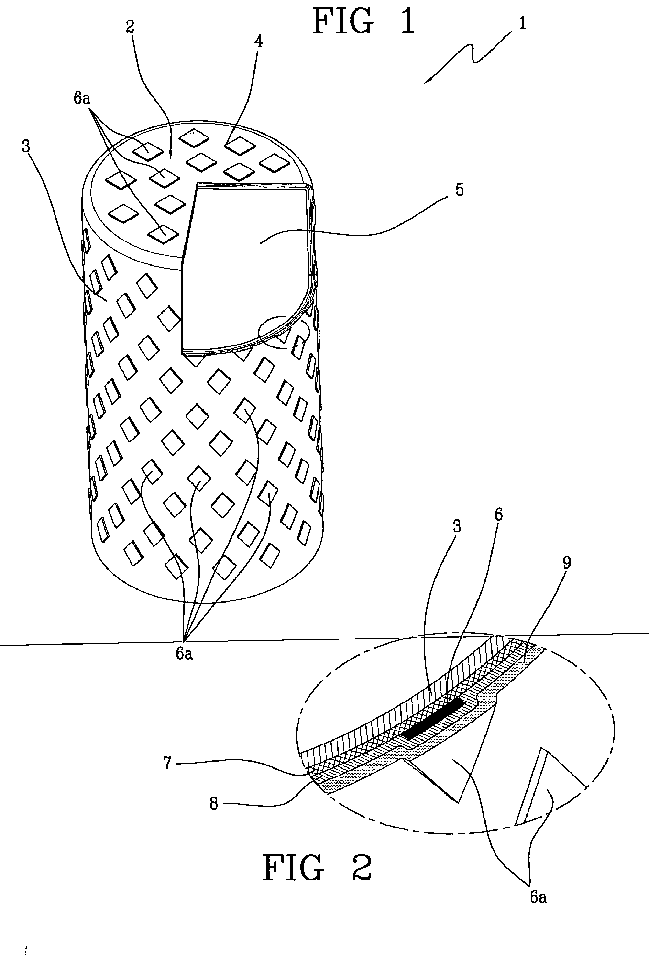

In some embodiments of the invention, before the printing-ink laying step 6, a step of laying a base coating 7 on the whole outer surface of the prismatic body 2 is provided (Fig. 2).

The base coating 7 has the function of coating the outer surface of the prismatic body 2 for either covering aesthetic faults created during production and/or transport or changing the properties of the outer surface of the prismatic body 2 so as to obtain precise aesthetic results following subsequent working operations on the surface itself, or for obtaining both results in combination.

In some cases, the base coating can be used for increasing surface adhesion of the layers that will be subsequently laid on the prismatic body (i.e. printing ink 6 and other layers to be described in the following).

Preferably, the base coating is applied onto the prismatic element by the airless painting technique, i.e. a type of painting in which paint atomisation takes place by forcing the paint to pass at a very high pressure (in the order of 35 bars) through a nozzle of reduced sizes. Thus air is not used for paint atomisation, and the paint is put under pressure by a pump sucking the paint, bringing it under pressure, and then sending it to the nozzle that will carry out atomisation. This type of painting enables paint overspray to be greatly reduced (limiting the paint waste) and an excellent covering of the prismatic body to be achieved.

The application time of the base coating is in the order of one second, i.e. 0.1-1 second.

Preferably, the paint used as the base coating has a solvent content in the range of 0 to 30% concentrations and is a paint containing a photostarter that, submitted to electromagnetic radiation gives rise to a chain cross-linking reaction of the paint.

To this aim, after the step of applying the base coating and before the printing-ink laying step, a drying step by UV rays is provided for making the paint cross-link.

0Note that exposure of the prismatic body to UV rays is in the order of a few seconds (0.5-4 seconds).

In addition to drying by means of UV rays, and in particular before the UV drying, a drying step using infrared rays may be provided for eliminating the possibly present small fractions of solvent in the paint. Exposure to infrared rays is in the order of few seconds (2-20 seconds).

After the ink laying step and in particular after the ink drying step, the prismatic element carrying the motif 6a is submitted to a step of metallising the whole side surface and top surface by a surface metal-laying process involving laying of a thin metal layer 8. In other words, the whole outer surface of the prismatic element 2 inclusive of the portions carrying the motif 6a, is metallised.

Preferably, the metallising step takes place using the sputtering technique. This technique is obtained through emission of atoms, or molecular fragments from a solid material, referred to as the "target", bombarded by a beam of energetic particles, generally ions. Ions strike on the target that, due to collision, releases atoms and particles that recondense on the surfaces of the item that is wished to be coated. The target is made of the same material of which the item coating is to be made. This process is carried out in a high-vacuum chamber.

Preferably, the metallising step by sputtering takes place through use of a metallising device comprising a main chamber maintained to a constant hard-vacuum condition in which true metallisation by the sputtering technique occurs.

A prechamber is disposed upstream of the main chamber and it too is maintained to a constant hard-vacuum condition. The prechamber is in fluid communication with the main chamber through a passage port. The prechamber is in turn connected to a loading and unloading chamber that is adapted to introduce the prismatic elements to be metallised into the prechamber.

The loading and unloading chamber can be switched between a vacuum condition and a ambient-pressure condition, to enable controlled introduction of each prismatic element into the main chamber (through the prechamber) .

In other words, in the loading and unloading chamber continuous pressurisation cycles are carried out when the loading and unloading chamber is in fluid communication with the external environment, and depressurisation cycles when the loading and unloading chamber is in fluid communication with the prechamber, in such a manner as to prepare the prismatic element to enter the main chamber and to prepare the just metallised element to go out of the metallising device.

Passage from the loading and unloading chamber to the main chamber takes place, as above said, through the prechamber. In this way, at each working cycle depressurisation is only required in the loading and unloading chamber having a much smaller volume than the main sputtering chamber and the prechamber, thus being minimised the energy required at each working cycle and the residence time of the prismatic element inside the metallisation chamber.

The residence time of each prismatic element within the metallising device is of few seconds, i.e. 2-6 seconds.

Note that other metallising techniques, in addition to sputtering, can be utilised such as metallisation by physical vapour deposition ((PVD), metallisation by chemical vapour deposition (CVD), metallisation by pulsed laser deposition (PLD), metallisation by plasma spray system (VPS).

After the metallising step, a step of applying a protective paint 9 over the whole outer surface of the prismatic element 2 is provided, for protecting the metallised layer against possible scratches or abrasions.

Preferably, the protective paint 9 is applied to the prismatic element using the airless painting technique.

The protective paint 9 utilised has a solvent content that can range from 0 to 30% concentrations and is a paint containing a photostarter that, submitted to electromagnetic radiation gives rise to a chain cross-linking reaction of the paint.

To this aim, a UV-ray drying step is provided for causing cross-linking of the paint.

Note that exposure to the UV rays is in the order of a few seconds (0.5-4 seconds).

In addition to UV ray drying, and in particular before this operation, an infrared drying step is provided for eliminating the possible presence of small fractions of solvent in the paint.

It should be noted that exposure to the infrared rays is in the order of few seconds (2-20 seconds).

The prismatic element 2 submitted to the above described steps produces a stopper that can be applied to the neck of a vessel, reaching the purposes of the invention.

The printing ink 6 laid according to the motif 6a and subsequently coated with a metal layer 8 enables the stopper to be handled in a safe manner by automatic machines, because there is no risk that the relief motif 6a may be crushed to such an extent that it is plastically deformed thus impairing the exterior appearance of the stopper.

In fact, by suitably balancing the amount of ink laid down on the prismatic element (on some parts thereof), any thickness of the relief motif 6a can be obtained.

This relief motif is the result of added material, therefore the motif 6a is provided with additional thickness added to the thickness belonging to the prismatic element 2 itself.

In this manner, the pressure necessary for deforming the relief motif 6a should be of such a nature as to "crush" the relief motif by compression. This pressure is far away from the working pressures of the handling devices of the automatic machines.

It should be further noticed that laying of the metal layer 8 both on the relief motif 6a and the surface of the prismatic body not concerned with the relief motif allows chromatic contrasts to be obtained that further emphasise the embossing aspect of the relief.

In fact, since the thickness of the laid metal is very reduced (in the order of a few millionth parts of one millimetre), the substrate (different between the part decorated with the motif 6a and the undecorated part of the prismatic element) has influence on the refractive index of the metal, optically highlighting the difference between the decorated part that is in relief and the undecorated part.

In addition, in the preferred embodiment of the invention, an overall working time of only some tens of seconds is required for producing a stopper. In fact, each step of the method takes place during a period of 2-4 seconds.

It has been also noted that the method of the present invention enables the embossing effect to be produced on any item that, submitted to pressure, could be spoiled at the relief decoration.

Falling within this category of items are for example bottles for cosmetic products and protection plates for electric outlets.

With reference to the two above mentioned products, the steps of the method would be the same as above described, except for the starting step of providing a hollow prismatic element that, in the first case (bottles for cosmetic products) would be replaced by a step of providing a body having a holding cavity, and in the second case (protection plates for electric outlets) would be replaced by a step of providing a body having constraint tailpieces for engagement with undercuts present in a contact-block holder.

## Claims

1. A method of producing stoppers for vessels, comprising the steps of:
- providing a prismatic element (2) having at least one side wall (3) and one top wall (4) defining an inner cavity (5);
- laying printing ink (6) only on some portions of said side wall (3) and/or top wall (4), said some portions on which printing ink (6) has been laid reproducing a predetermined motif (6a);
- subsequent to deposition of said printing ink (6), fully metallising both said side wall (3) and top wall (4) by a surface deposition process for laying a thin metal layer (8).

2. A method as claimed in claim 1, wherein the step of laying printing ink (6) is carried out by digital printing technique.

3. A method as claimed in claim 2, wherein said digital printing technique is an inkjet printing technique.

4. A method as claimed in anyone of the preceding claims, comprising the step of drying said printing ink (6) after the deposition step and before the metallisation step.

5. A method as claimed in claim 4, wherein said printing ink (6) is a UV ink; said drying step being carried out by submitting the whole prismatic element (2) to UV rays.

6. A method as claimed in anyone of the preceding claims, wherein said metallisation step is carried out using the sputtering technique.

7. A method as claimed in anyone of the preceding claims, comprising the step of applying a protective paint (9) on said prismatic element (2) after the metallisation step.

8. A method as claimed in claim 7, wherein the protective paint (9) is applied using an airless technique.

9. A method as claimed in anyone of the preceding claims, comprising the step of applying a base coating onto said prismatic element (2) before the printing-ink deposition step.

10. A method as claimed in anyone of the preceding claims, wherein said predetermined motif (6a) is one alone or a combination of: inscriptions, badges, logos, marks, effigies, decorations, photographic reproductions.
